# FASCICULE DE BREVET EUROPEEN

(11) **EP 4 053 883 B1**
(45) Date de publication et mention de la délivrance du brevet: **29.11.2023**
(21) Numéro de dépôt: 22158663.9
(22) Date de dépôt: 24.02.2022
(51) Int. Cl.: H01L 21/311, H01L 29/66

(54) **PROCÉDÉ DE GRAVURE D'UNE COUCHE DIÉLECTRIQUE TRIDIMENSIONNELLE**
VERFAHREN ZUM ÄTZEN EINER DIELEKTRISCHEN DREIDIMENSIONALEN SCHICHT
METHOD FOR ETCHING A THREE-DIMENSIONAL DIELECTRIC LAYER

(30) Priorité: 25.02.2021 FR 2101866
(43) Date de publication de la demande: 07.09.2022
(73) Titulaire: Commissariat à l'énergie atomique et aux énergies alternatives, 75015 Paris (FR)
(72) Inventeur: POSSEME, Nicolas, 38054 GRENOBLE Cedex 09 (FR); BACQUIE, Valentin, 38054 GRENOBLE Cedex 09 (FR)
(74) Mandataire: Hautier IP

(56) Documents cités:
- EP-A1- 3 107 125
- EP-B1- 3 506 336

## Description

### DOMAINE TECHNIQUE

La présente invention concerne en général la gravure de couches sur des structures microélectroniques, notamment tridimensionnelles (3D).

Elle trouve pour application particulièrement avantageuse la réalisation de transistors de type FinFET, c'est-à-dire de transistors à effet de champ (FET) dont le canal de conduction comprend une lamelle verticale d'un matériau semi-conducteur, qualifiée du terme anglais de « fin ».

### ETAT DE LA TECHNIQUE

Pour améliorer les performances électriques des transistors, des architectures tridimensionnelles (3D) ont été développées. C'est par exemple le cas des architectures de transistors à base de nanofils et des architectures FinFET.

Un enjeu important des procédés de fabrication des transistors présentant une architecture 3D est la maîtrise de la gravure des espaceurs de ces transistors.

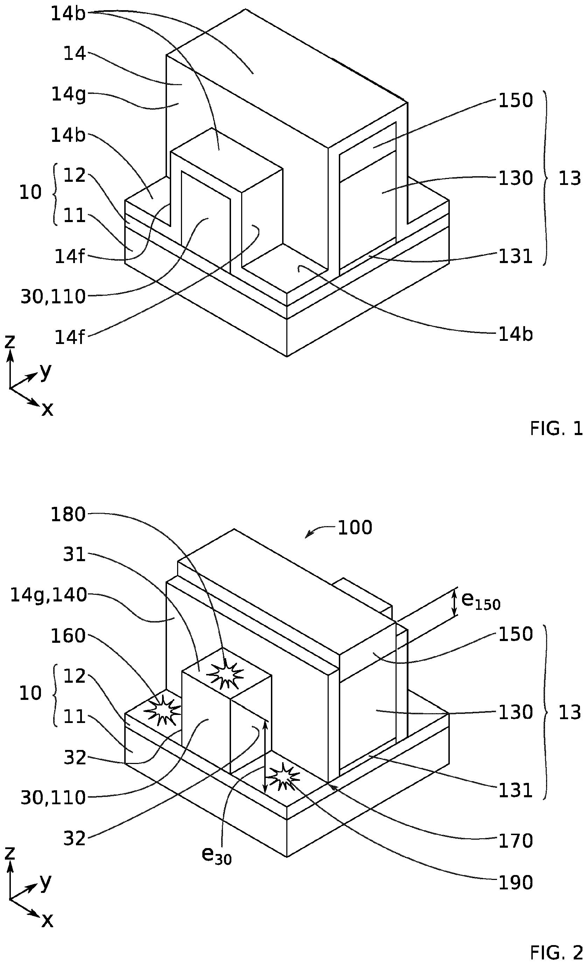

A titre d'exemple, un transistor 100 de type FinFET est illustré aux figures 1 et 2, respectivement avant gravure des espaceurs et après gravure des espaceurs. Dans cette architecture 3D, le canal 110 de conduction est constitué d'une lamelle verticale de matériau semi-conducteur, typiquement du silicium. La lamelle formant le canal 110 est entourée sur trois côtés par le motif de grille 13. La lamelle traverse de part en part le motif de grille 13 et se prolonge pour former de part et d'autre du motif de grille 13 des nageoires ou «Fin» 30. Ces Fin constituent ainsi des structures tridimensionnelles (3D).

Pour former les espaceurs 140 sur les flancs du motif de grille 13, un dépôt conforme d'une couche en un matériau diélectrique est d'abord effectué sur le motif de grille 13 et le Fin 30 (figure 1).

Comme illustré sur la figure 2, la gravure de la couche diélectrique 14 est idéalement configurée pour retirer les portions basales 14b et les portions latérales de Fin 14f en conservant les seules portions latérales de grille 14g formant les espaceurs 140. Ainsi, toutes les autres portions de couche 14, en particulier celles couvrant le Fin 30, qu'elles soient perpendiculaires ou parallèles au plan basal XY du substrat 10, doivent être gravées complètement. Ceci doit être effectué sans laisser 190 de résidus et sans endommager 160 les couches sous-jacentes à la couche diélectrique 14, typiquement sans endommager le sommet 31 des Fin 30 et/ou sans endommager la face supérieure du BOX 12 (acronyme de « burried oxide » ou oxyde enterré en français). Par ailleurs il est important que la gravure soit anisotrope selon z de façon à éviter 170 la formation de pieds à la base des espaceurs 140.

Le document EP 3506336 B1 prévoit une formation de tels espaceurs en répétant plusieurs séquences d'étapes d'oxydation et de gravure. Ce procédé vise à consommer la couche diélectrique sur les flancs du Fin tout en protégeant le sommet du Fin.

En pratique cependant, la mise en oeuvre de ce procédé de gravure ne s'avère pas optimale. Le sommet du Fin reste impacté. Un retrait de matière couramment appelé « recess » est typiquement observé au sommet du Fin sur une profondeur de 1 à 2 nm. La précision en profondeur de gravure et/ou l'arrêt de gravure restent ainsi perfectibles.

Il existe donc un besoin consistant à proposer une solution pour graver entièrement et avec une grande précision une couche diélectrique située sur des faces d'une structure 3D tout en évitant d'endommager cette structure 3D.

Un objet de la présente invention est de pallier les limitations des solutions connues.

Dans le cadre particulier et non limitatif des transistors de type FinFET, un objectif de la présente invention consiste à proposer une solution pour graver sur les Fins la couche diélectrique destinée à former des espaceurs sur les flancs de la grille, tout en évitant, voire en supprimant, les résidus de couche diélectrique de part et d'autre des Fins ainsi que la consommation de couches sous-jacentes à la couche diélectrique telle que la couche semi conductrice formant le Fin.

Un autre objet de la présente invention est de proposer un procédé de fabrication d'espaceurs permettant un meilleur contrôle de l'arrêt de gravure au sommet de structures tridimensionnelles telles que des Fin.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation on prévoit un procédé de gravure d'une couche diélectrique recouvrant au moins un sommet et un flanc d'une structure tridimensionnelle de préférence à base d'un matériau semi-conducteur. Le procédé de l'invention comprend un dépôt de ladite couche diélectrique sur le sommet et le flanc de la structure tridimensionnelle.

Le procédé comprend une pluralité de séquences comprenant chacune au moins les étapes successives suivantes :
- une première gravure de la couche diélectrique, par un premier plasma à base d'une chimie comprenant :
   ∘ au moins un premier composé à base de fluor (F) et
   ∘
   ∘ de l'oxygène (O),
ladite première gravure étant effectuée de manière à :
∘ générer un bombardement ionique dirigé principalement selon une direction parallèle audit flanc,
∘ réguler la quantité de l'au moins un premier composé pour consommer tout ledit premier composé à base de fluor lors de cette première gravure de manière à interrompre la première gravure avant consommation de toute l'épaisseur de la couche diélectrique située sur le flanc et après avoir consommé toute l'épaisseur de la couche diélectrique située au niveau du sommet,
∘ former une première couche de protection à base d'oxyde au niveau du sommet de la structure tridimensionnelle et former une deuxième couche de protection à base d'oxyde sur une portion supérieure de la couche diélectrique située sur le flanc, l'épaisseur e50a de la première couche de protection étant supérieure à l'épaisseur e60a de la deuxième couche de protection,

- une deuxième gravure dirigée principalement selon la direction parallèle audit flanc et configurée pour retirer entièrement la deuxième couche de protection tout en conservant une portion d'épaisseur e50b de la première couche de protection au-dessus du sommet de la structure.

Cette séquence de première et deuxième gravures est répétée jusqu'au retrait complet de la couche diélectrique située sur le flanc de la structure.

Le procédé comprend en outre, avant le dépôt de la couche diélectrique, une formation d'une couche de protection intercalaire à base d'un matériau de protection différent du matériau diélectrique, la couche de protection intercalaire étant formée de sorte à recouvrir entièrement la structure tridimensionnelle, de sorte que ladite couche de protection intercalaire soit située entre ledit sommet et la couche diélectrique.

La couche diélectrique ne recouvre pas directement le sommet de la structure tridimensionnelle, et de préférence pas directement le flanc de la structure tridimensionnelle, contrairement au procédé divulgué par le document EP 3506336 B1. La couche diélectrique recouvre néanmoins indirectement le sommet de la structure tridimensionnelle, et de préférence indirectement le flanc de la structure tridimensionnelle, comme le procédé divulgué par le document EP 3506336 B1. Il apparaît donc de façon parfaitement claire que le recouvrement, ainsi que les termes « sur » ou « au-dessus », ne signifient pas nécessairement « au contact de ».

Le sommet de la structure tridimensionnelle est ainsi protégé par la couche de protection intercalaire avant la première gravure de la couche diélectrique.

Dans le cadre du développement de la présente invention, il a en effet été observé que la première gravure telle que divulguée par le document EP 3506336 B1 entraînait typiquement une amorphisation du matériau semi-conducteur au niveau du sommet de la structure 3D. Il est apparu lors du développement de la présente invention que cette amorphisation du sommet de la structure 3D survenait notamment avant la formation initiale de la première couche de protection, ou juste au début de cette formation initiale, lorsque la première couche de protection ne présente pas encore une épaisseur suffisante pour empêcher une implantation des ions énergétiques mis en oeuvre lors de la première gravure, dans le matériau de la structure 3D.

Pour limiter ou supprimer l'endommagement par amorphisation du sommet de la structure 3D, une solution alternative à celle proposée dans la présente invention a d'abord été envisagée dans le cadre du développement de la présente invention. Cette solution alternative consiste à diminuer l'énergie des ions à base d'espèces fluorées ou fuorocarbonées lors de la première gravure. Cette solution alternative n'a pas été retenue, parce qu'il a été observé, dans le cadre du développement de la présente invention, que cette solution entraîne lors des première et/ou deuxième gravures une dégradation du contrôle dimensionnel des espaceurs, également couramment appelé contrôle du CD ou simplement CD (acronyme de « Critical Dimension »).

La présente invention se base au contraire sur un principe différent, qui consiste à protéger le sommet de la structure 3D préalablement au dépôt de la couche diélectrique. Le sommet de la structure 3D est ainsi préservé d'un recess ultérieur. Par ailleurs, toute la couche diélectrique située sur le flanc de la structure 3D est gravée de façon contrôlée sans craindre un endommagement du sommet de la structure 3D.

En effet, la chimie utilisée lors de la première gravure, combinant espèces fluorées ou fluorocarbonées et au moins un gaz à base de silicium permet de graver efficacement la couche diélectrique. La présence d'oxygène dans le plasma conduit à la formation d'une couche de protection dont l'épaisseur est plus importante sur le matériau de protection de la couche de protection intercalaire que sur la couche diélectrique.

La deuxième gravure permet de retirer la couche de protection sur la couche diélectrique, tout en conservant une partie de cette couche de protection sur le matériau de protection. Lors de la première gravure de la séquence suivante, le sommet de la structure 3D sera donc protégé à la fois par le résidu de la première couche de protection et par la couche de protection intercalaire. Le sommet de la structure 3D ne sera pas gravé, tandis que la couche diélectrique, mise à nu, se gravera aisément.

En répétant cette séquence d'étapes, on grave ainsi rapidement la couche diélectrique tout en protégeant la structure 3D.

Ainsi, la présente invention propose une solution efficace pour graver entièrement et avec une grande précision la couche diélectrique sur le sommet et les flancs d'une structure 3D tout en évitant d'endommager cette structure 3D.

Avantageusement, au moins un effet supplémentaire est obtenu grâce à l'utilisation d'un matériau de protection à base de SiXO, avec X une espèce prise parmi le carbone (C) et l'azote (N). L'utilisation de SiCO ou de SiON permet en effet de favoriser la formation de la première couche de protection sur la couche de protection intercalaire, lors de la première gravure. L'épaisseur de la première couche de protection à base d'oxyde formée sur une telle couche de protection intercalaire est ainsi supérieure à l'épaisseur d'une première couche de protection à base d'oxyde formée directement sur le sommet de la structure 3D, toutes choses étant égales pas ailleurs. Cet effet synergique améliore encore plus la protection du sommet de la structure 3D.

Contrairement aux solutions connues, même optimisées, le procédé de gravure selon l'invention permet ainsi avantageusement d'améliorer significativement la protection du sommet de la structure 3D tout en permettant de graver efficacement et de façon sûre la couche diélectrique sur les flancs de la structure 3D.

Lorsque la structure 3D est destinée à former un transistor de type FinFET, la présente invention propose ainsi une solution efficace pour graver la couche diélectrique déposée sur les Fins, tout en évitant, voire en supprimant, un recess des couches sous-jacentes à la couche diélectrique, en particulier au niveau du sommet des Fins.

Un autre aspect de la présente invention concerne un procédé de réalisation d'un transistor FinFET surmontant un substrat de support, le transistor FinFET comprenant un motif de grille et au moins un canal traversant le motif de grille et s'étendant depuis un flanc du motif de grille pour former au moins une structure de préférence faite en un matériau semiconducteur, ladite structure présentant un sommet et au moins deux flancs.

Le procédé comprend :
- la gravure de la couche diélectrique en mettant en oeuvre le procédé selon l'un quelconque des modes de réalisation du procédé de gravure selon l'invention, de manière à retirer complètement la couche diélectrique située sur la structure formée par le canal en conservant une portion de couche diélectrique sur le flanc du motif de grille, de façon à ce que ladite portion forme un espaceur du transistor FinFET.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
La figure 1 illustre schématiquement un transistor de type FinFET en cours de réalisation, avant gravure des espaceurs, selon l'art antérieur.
La figure 2 illustre schématiquement un transistor de type FinFET en cours de réalisation, après gravure des espaceurs, selon l'art antérieur.
Les figures 3A à 3J illustrent schématiquement des étapes d'un procédé de gravure selon un mode de réalisation de la présente invention.
La figure 4 illustre schématiquement un transistor de type FinFET en cours de réalisation, avant gravure des espaceurs, selon un mode de réalisation de la présente invention.
La figure 5 illustre schématiquement un transistor de type FinFET en cours de réalisation, après gravure des espaceurs, selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs des différentes couches et portions, et les dimensions des motifs ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, le matériau de protection est choisi de façon à présenter une résistance à la gravure par l'acide fluorhydrique (HF), telle qu'une vitesse de gravure dudit matériau par une solution à base de HF soit inférieure à 5 nm/min. Cela permet d'éviter un retrait des espaceurs par lift off lors de la mise en oeuvre du procédé dans le cadre de la fabrication des espaceurs d'un transistor FinFET, lors du retrait par HF de la couche de protection intercalaire modifiée.

Selon un exemple, le matériau de protection est choisi de façon à présenter une constante diélectrique k inférieure ou égale à 4. Cela permet d'obtenir une couche de protection intercalaire compatible avec la fabrication d'espaceurs, notamment lors de la mise en oeuvre du procédé dans le cadre de la fabrication des espaceurs d'un transistor FinFET.

La couche de protection intercalaire est formée de sorte à recouvrir entièrement la structure tridimensionnelle.

Selon un exemple, la couche de protection intercalaire est formée directement au contact du sommet de la structure tridimensionnelle.

Selon un exemple, la deuxième gravure est effectuée par un deuxième plasma à base d'au moins une espèce fluorocarbonée CxHyFz, x, y et z étant des entiers.

Selon un exemple, la formation de la couche de protection intercalaire est configurée de sorte à ce que la couche de protection intercalaire présente une épaisseur e20 comprise entre 2 nm et 5 nm.

Selon un exemple, la première gravure est configurée de sorte à ce que la première couche de protection à base d'oxyde formée présente une épaisseur e50a supérieure ou égale à 5 nm.

Selon un exemple, la deuxième gravure est configurée de sorte à ce que la portion de la première couche de protection conservée présente une épaisseur e50b supérieure ou égale à 2 nm.

Selon un exemple, le procédé comprend une étape préalable d'oxydation de la couche diélectrique effectuée avant ladite séquence d'étapes, l'étape préalable d'oxydation étant destinée à limiter une gravure latérale de la couche diélectrique lors de la première gravure.

Selon un exemple de réalisation, le procédé comprend une étape préalable de gravure de la couche diélectrique, effectuée avant ladite séquence d'étapes, l'étape préalable de gravure étant interrompue de manière à conserver une portion de la couche diélectrique située sur la couche de protection intercalaire, au niveau du sommet de la structure. Cette étape permet typiquement de graver une portion importante de la couche diélectrique. Elle permet d'augmenter la rapidité du procédé.

Selon un exemple de réalisation, l'étape préalable de gravure de la couche diélectrique est basée sur une chimie fluorocarbonée (par exemple CxFy ou CxHyFz).

Dans la suite de la description, on considère que les chimies fluorocarbonées comprennent notamment les composés fluorocarbonés (CxFy) et les composés hydrofluorocarbonés (CxHyFz).

Selon un exemple de réalisation, ledit premier composé à base de fluor (F) de la chimie utilisée pour la première étape de gravure provient, de préférence intégralement, de la chimie utilisée lors de ladite étape préalable de gravure.

Alternativement, une partie au moins et optionnellement tout le premier composé à base de fluor (F) de la chimie utilisée pour la première étape de gravure est fourni durant la première étape de gravure.

Selon un exemple de réalisation, le premier composé à base de fluor (F) provient de la dissociation d'au moins un composé pris parmi les composés fluorocarbonés (par exemple CxFz ou CxHyFz).

Selon un exemple, les première et deuxième gravures sont effectuées dans un même réacteur.

Selon un exemple, le réacteur est configuré pour former un plasma par couplage capacitif.

Selon un exemple alternatif, le réacteur est configuré pour former un plasma par couplage inductif.

Selon un exemple de réalisation, la structure est en un matériau semi-conducteur et forme un canal d'un transistor FinFET.

Selon un exemple de réalisation, le motif de grille comprend une grille et un masque dur surmontant ladite grille.

Selon un exemple, l'épaisseur de masque dur est supérieure ou égale à la hauteur de la structure formant le canal d'un transistor FinFET.

Selon un exemple, le masque dur présente une épaisseur e150, tel que e150 ≥ e30, e30 étant à la hauteur de la structure (30), et de préférence e150 ≥ 1.2 * e30. Ainsi, lorsque la gravure consomme entièrement la couche diélectrique située sur les flancs de la structure, toute la hauteur des flancs de la grille reste recouverte par la couche diélectrique. Par conséquent, le retrait de la couche diélectrique sur les flancs du Fin n'entraîne pas de retrait de cette couche diélectrique sur les flancs de la grille. La couche diélectrique restant sur les flancs de la grille forme typiquement les espaceurs du transistor FinFET.

Selon un exemple de réalisation, le ou les flancs de la structure 3D s'étendent selon un plan perpendiculaire (YZ) à un plan principal (XY) selon lequel le substrat de support s'étend.

Selon un exemple de réalisation, le sommet s'étend principalement dans un plan parallèle au plan (XY) du substrat de support.

Selon un exemple de réalisation, ladite structure 3D est formée par au moins un bloc ou une lamelle de matériau semi-conducteur.

De préférence, le matériau semi-conducteur est du silicium. Le matériau semi-conducteur peut alternativement être du germanium (Ge) ou du silicium-germanium SiGe. La structure en un matériau semi-conducteur peut également être faite d'une succession de couches, chaque couche étant par exemple prise parmi les matériaux suivants: silicium (Si), germanium (Ge), silicium-germanium (SiGe). Ainsi pour la réalisation de nanofils on pourra prévoir une succession de couches formée chacune de Si ou de SiGe.

Selon un exemple, le matériau diélectrique de la couche diélectrique est pris parmi : le SiN, le Si3N4, le SiC, le SiCN, le SiCBN.

Selon un exemple de réalisation, lorsque la couche diélectrique située sur le flanc de la structure est entièrement gravée, on effectue ensuite une étape de retrait de la première couche de protection.

De préférence, ce retrait de la première couche de protection est effectué à l'aide d'une solution à base d'acide fluorhydrique (HF).

Selon un exemple, le procédé comprend en outre, après retrait complet de la couche diélectrique située sur le flanc de la structure tridimensionnelle, une étape d'oxydation de la couche de protection intercalaire suivie d'une étape de retrait de la couche de protection intercalaire oxydée.

Selon un exemple, le matériau de protection de la couche de protection intercalaire est du SiCO, et l'étape d'oxydation est effectuée par un plasma à base d'oxygène de sorte que la couche de protection intercalaire oxydée soit à base de SiO2.

Selon un exemple, l'étape de retrait de la couche de protection intercalaire oxydée se fait par une solution de gravure à base d'acide fluorhydrique (HF).

Selon un exemple, le procédé est un procédé de formation des espaceurs d'un transistor comprenant un motif de grille et une structure tridimensionnelle attenante audit motif de grille, le motif de grille et la structure tridimensionnelle étant portés par une face supérieure d'un substrat, ladite face supérieure s'étendant selon un plan basal xy, le motif de grille et la structure tridimensionnelle présentant respectivement, selon une direction z normale au plan basal xy, une dimension en hauteur hg et une dimension en hauteur h30 telles que hg > h30, le motif de grille présentant en outre des premiers flancs latéraux et ladite structure tridimensionnelle présentant un sommet et des deuxièmes flancs latéraux, ledit procédé comprenant :
- une formation d'une couche diélectrique en un matériau diélectrique recouvrant les premiers flancs latéraux du motif de grille, le sommet et les deuxièmes flancs latéraux de la structure tridimensionnelle et au moins partiellement la face supérieure du substrat de part et d'autre du motif de grille, ladite couche diélectrique présentant des premières portions latérales recouvrant les premiers flancs latéraux, des deuxièmes portions latérales recouvrant les deuxièmes flancs latéraux, au moins une première portion basale recouvrant le sommet de la structure tridimensionnelle et des deuxièmes portions basales recouvrant la face supérieure du substrat, une pluralité de séquences comprenant chacune au moins les étapes successives suivantes :
- une première application d'un premier plasma configuré pour former un film d'oxyde épais au niveau des première et deuxièmes portions basales et un film d'oxyde mince sur une partie supérieure des premières et deuxièmes portions latérales,
- une deuxième application d'un deuxième plasma configuré pour graver selon la direction z :
   ∘ le film d'oxyde épais en partie seulement, et
   ∘ le film d'oxyde mince totalement et une partie au moins des premières et deuxièmes portions latérales de la couche diélectrique,

ladite séquence étant répétée jusqu'au retrait complet des deuxièmes portions latérales recouvrant les deuxièmes flancs latéraux de la structure tridimensionnelle, une partie restante des premières portions latérales de la couche diélectrique formant les espaceurs,
ledit procédé comprenant en outre, avant la formation de la couche diélectrique, une formation d'une couche de protection intercalaire à base d'un matériau de protection différent du matériau diélectrique, au moins sur le sommet de la structure tridimensionnelle, de façon à protéger ledit sommet lors de la gravure selon la direction z du film d'oxyde épais.

Sauf incompatibilité, il est entendu que l'ensemble des caractéristiques optionnelles ci-dessus peuvent être combinées de façon à former un mode de réalisation qui n'est pas nécessairement illustré ou décrit. Un tel mode de réalisation n'est évidemment pas exclu de l'invention.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants. Ainsi, une couche à base de silicium s'entend par exemple d'une couche Si, Si dopé n, Si dopé p, SiGe. Une couche à base de germanium s'entend par exemple d'une couche Ge, Ge dopé n, Ge dopé p, SiGe.

Le mot « diélectrique » qualifie un matériau dont la conductivité électrique est suffisamment faible dans l'application donnée pour servir d'isolant. Dans la présente invention, un matériau diélectrique présente de préférence une constante diélectrique inférieure à 7.

On entend par « nature » d'un matériau, sa composition chimique et/ou sa structure cristalline. Ainsi deux couches peuvent être de même composition chimique mais de nature différente d'un point de vue cristallographique.

Plusieurs modes de réalisation de l'invention mettant en oeuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, l'épaisseur d'une couche est prise selon une direction normale au plan d'extension principal de la couche. Ainsi, une couche présente typiquement une épaisseur selon z. Les termes relatifs « sur », « surmonte », « sous », « sous-jacent » se réfèrent à des positions prises selon la direction z.

Les termes « vertical », « verticalement » se réfèrent à une direction selon z. Les termes « horizontal », « horizontalement » se réfèrent à une direction dans le plan xy. Le terme « latéral » se réfère à un plan xz ou yz. Ainsi, les flancs latéraux de la grille s'étendent parallèlement à un plan yz. Les flancs latéraux de la structure Fin s'étendent parallèlement à un plan xz. Sauf mention explicite, l'épaisseur, la hauteur et la profondeur sont mesurées selon z.

Un élément situé « à l'aplomb » ou « au droit d'» un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

Dans le cadre de la présente invention, on désigne par structure en trois dimensions une structure formant une saillie au-dessus d'une couche qui lui est sous-jacente tel un substrat de support.

Dans le cadre de la présente invention, un exemple non limitatif mais particulièrement avantageux de structure 3D est une lamelle (également désignée nageoire ou par son vocable anglais Fin) formant l'extension d'un canal de transistor FinFET, tel qu'illustré à la figure 2. Comme mentionné plus haut, la formation des espaceurs flanquant le motif de grille de ce transistor FinFET requiert une gravure précise des parties de la couche diélectrique recouvrant le Fin.

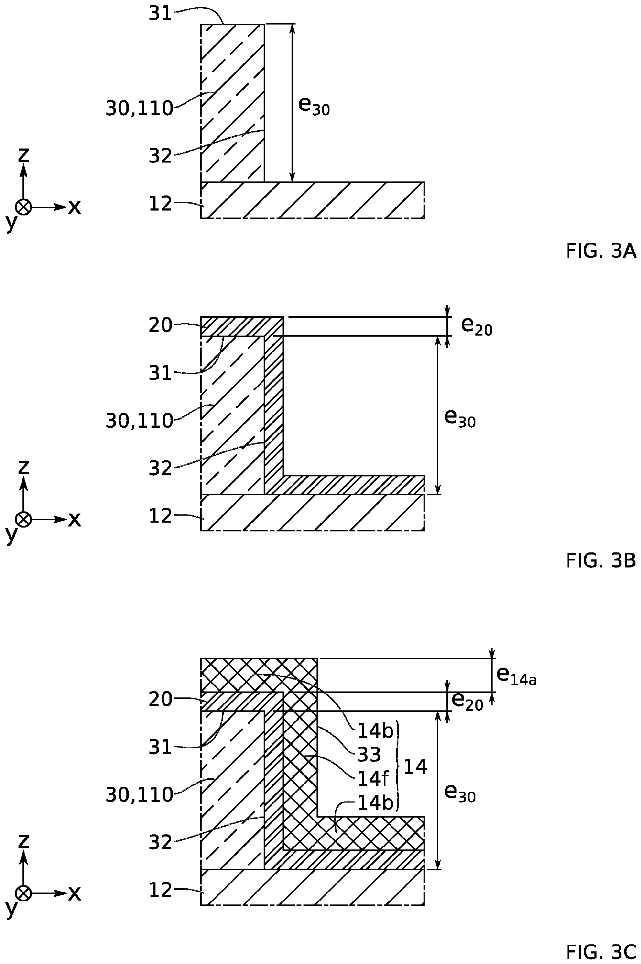

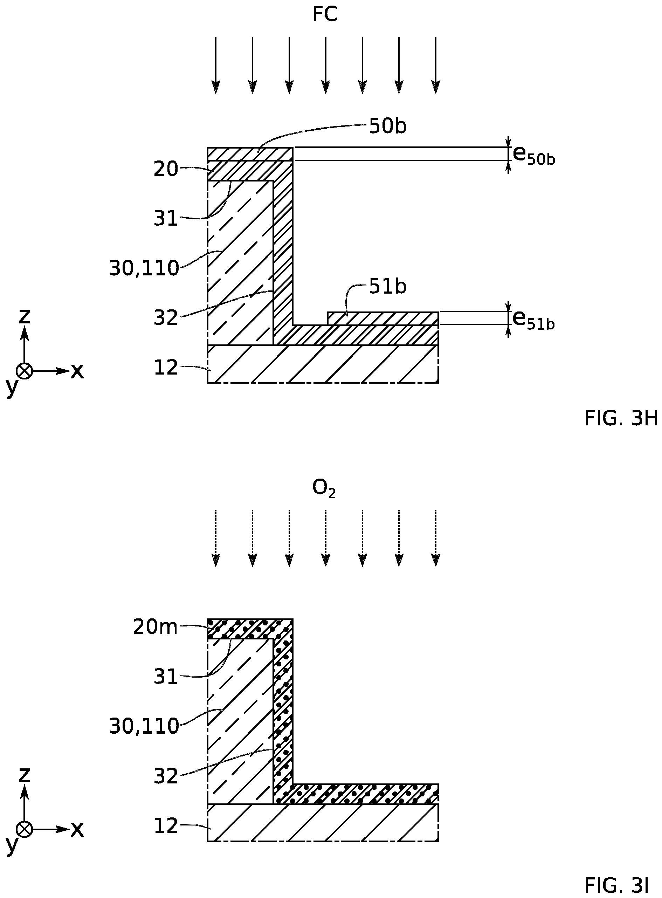

Les figures 3A à 3J illustrent un mode de réalisation du procédé de gravure de la couche diélectrique 14 selon l'invention. Selon ce mode de réalisation non limitatif, une structure initiale sous forme de Fin 30 d'un transistor FinFET est fournie. Par souci de clarté, seul le Fin 30 du transistor FinFET est reproduit sur les figures 3A à 3J, en coupe transverse selon un plan xz. Seul un flanc 32 du Fin 30 est représenté. Les mêmes étapes et caractéristiques s'appliquent aux autres flancs du Fin 30 perpendiculaires au plan basal xy. Il est entendu que ce Fin 30 est de préférence attenant à un motif de grille 13 comprenant de façon connue une grille 130, un masque dur 150 et optionnellement une couche 131 à haute constante diélectrique dite « high k », comme illustré par exemple en figure 1.

Toutes les caractéristiques, étapes et avantages techniques qui vont être décrits par la suite s'appliquent également à des modes de réalisation dans lesquels la couche diélectrique 14 surmonte une structure tridimensionnelle différente d'un Fin d'un transistor FinFET. Par exemple ils s'appliquent à des structures formant des nanofils et en particulier des nanofils empilés.

Le Fin 30 est ici supporté par un substrat comprenant typiquement une partie supérieure 12 à base d'oxyde (figure 3A). La hauteur e30 du Fin 30 est référencée sur la figure 3A. Par exemple, la hauteur e30 du Fin, mesurée selon la direction Z depuis la face supérieure 120 de la partie supérieure 12 du substrat, est comprise entre quelques nanomètres et quelques dizaines de nanomètres. Préférentiellement, e30 est compris entre 10 et 200 nanomètres et encore plus préférentiellement, e30 est compris entre 32 et 150 nm et encore plus préférentiellement.

La partie supérieure 12 du substrat peut typiquement correspondre à une couche d'oxyde enterré BOX provenant d'un substrat de type silicium sur isolant SOI. D'autres substrats, par exemple en matériau semiconducteur massif, peuvent alternativement être utilisés. En particulier, la partie supérieure 12 n'est pas nécessairement à base d'oxyde.

Selon un principe de la présente invention, une couche de protection intercalaire 20 est formée sur le sommet 31 du Fin 30, préalablement au dépôt de la couche diélectrique à graver, comme illustré en figure 3B. Cette couche de protection intercalaire 20 peut être typiquement déposée de façon conforme sur le sommet 31 et le flanc 32 du Fin 30, et à la surface 120 du BOX 12. Elle peut être formée par dépôt chimique en phase vapeur assisté par plasma (PECVD, acronyme de plasma enhanced chemical vapor déposition), dépôt chimique en phase vapeur à basse pression (LPCVD, acronyme de low pressure CVD), dépôt par couche atomique assistée par plasma (PEALD, acronyme de plasma enhanced atomic layer déposition). Elle est de préférence directement au contact du sommet 31, du flanc 32, et de la surface 120.

La couche de protection intercalaire 20 est avantageusement à base d'un matériau favorisant une recroissance ultérieure d'oxyde et résistant au HF. Elle est de préférence à base de SiCO, SiON ou SiOCH. En particulier, le SiCO présente plusieurs avantages dans le cadre de la gravure de la couche diélectrique par les séquences d'étapes détaillées par la suite. Ce matériau de protection est en particulier résistant aux premières gravures et résistant au HF. Il peut être transformé en SiO2 ou SiOx par exposition à un plasma d'oxygène par exemple, pour être ensuite facilement éliminé. Il favorise en outre la croissance de SiOx lors de la première gravure.

Le matériau de protection de la couche de protection intercalaire 20 est en outre de préférence compatible avec la fabrication d'espaceurs. Il présente de préférence une faible constante diélectrique k, par exemple inférieure à 4. Le SiCO présente typiquement une constante diélectrique k de cet ordre (k≤4) et peut parfaitement jouer le rôle d'espaceur ou entrer dans la composition d'un espaceur.

La couche de protection intercalaire 20 présente typiquement une épaisseur e20 sensiblement constante, par exemple comprise entre 2nm et 5 nm, typiquement de l'ordre de 3nm.

Comme illustrée à la figure 3C, la couche de protection intercalaire 20 est ensuite recouverte par une couche diélectrique 14 comprenant des portions basales 14b et une ou plusieurs portions latérales 14f.

De préférence, cette couche diélectrique 14 est une couche conforme.

Dans cet exemple lié aux transistors FinFET, cette couche diélectrique 14 est destinée à former des espaceurs sur les flancs de la grille 130. Cette couche diélectrique 14 est alors formée dans des matériaux présentant une faible constante diélectrique. Cette couche diélectrique 14 peut être poreuse ou non. Elle est par exemple formée dans l'un des matériaux suivants : SiC, SiCN, SiCBN, ou un nitrure de silicium (SixNy, x et y étant des entiers), typiquement du SiN.

Une fois déposée, cette couche diélectrique 14 présente par exemple une épaisseur e14a comprises entre 4 et 50 nanomètres, de préférence entre 4 et 30 nanomètres et de préférence entre 8 et 12 nanomètres. L'épaisseur e14a est mesurée selon la direction Z. Elle est référencée en figure 3A.

Cette couche diélectrique 14 est par exemple formée par l'une des techniques suivantes: dépôt chimique en phase vapeur assisté par plasma (PECVD, acronyme de plasma enhanced chemical vapor déposition), dépôt chimique en phase vapeur à basse pression (LPCVD, acronyme de low pressure CVD), dépôt par couche atomique assistée par plasma (PEALD, acronyme de plasma enhanced atomic layer déposition).

À partir de la structure illustrée en figure 3C plusieurs étapes vont être mises en oeuvre dans le but de retirer entièrement la couche diélectrique 14, sans laisser de résidus de couche diélectrique et sans endommager le Fin 30 et la partie supérieure 12 du substrat.

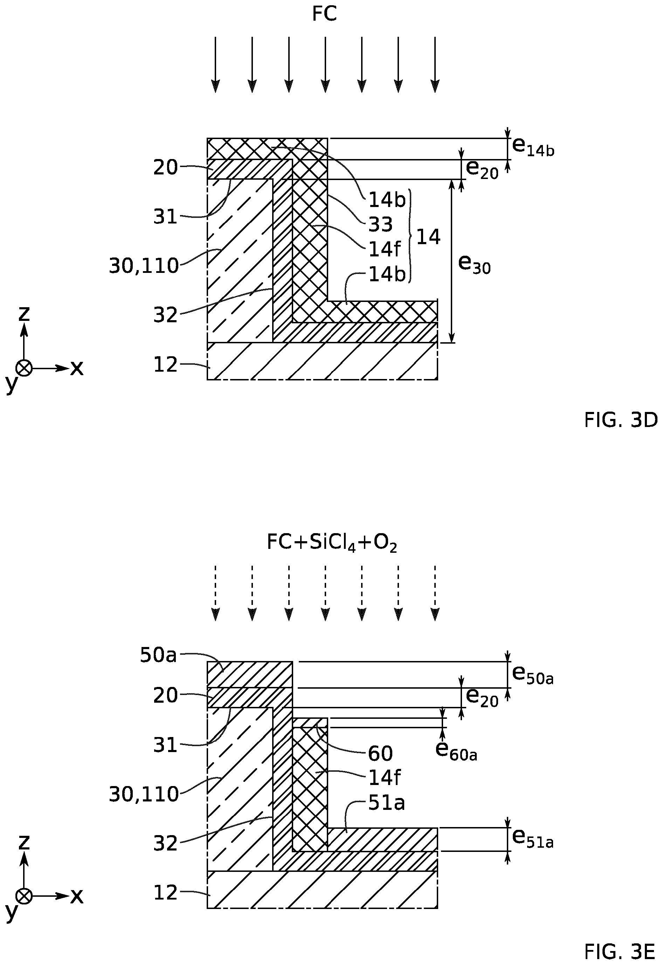

La figure 3D illustre une étape optionnelle au cours de laquelle une partie seulement de l'épaisseur de la couche diélectrique 14 est retirée sur les zones parallèles au plan XY du substrat. Cette étape de retrait comprend principalement une gravure anisotrope dirigée selon z. Cette gravure anisotrope permet d'augmenter la rapidité du procédé avant les étapes ultérieures qui vont permettre une gravure très précise.

Typiquement, au cours de cette étape préalable de gravure, plus de 70 % et de préférence plus de 80 % et encore plus préférentiellement plus de 90 % de l'épaisseur initiale e14a de la couche diélectrique 14 est gravée.

Typiquement, à l'issue de la gravure, la couche diélectrique 14 présente une épaisseur résiduelle e14b supérieure à 2 nm, de préférence supérieure à 3 nm et de préférence supérieure à 4 nm. Typiquement, l'épaisseur e14b résiduelle est comprise entre 2 et 3 nm, de façon à limiter le bombardement ionique dans la couche de protection intercalaire 20 sous-jacente, lors de cette gravure préalable.

Cette étape de gravure est par exemple effectuée dans un équipement de gravure de type réacteur plasma à couplage inductif (ICP), ou réacteur plasma à couplage capacitif (CCP).

Cette étape de gravure par plasma est basée sur une chimie comprenant un composé à base de fluor (F). De préférence, cette chimie comprend une espèce fluorocarbonée, par exemple pris parmi les espèces suivantes CxHyFz ou CxFy, x, y et z étant des entiers. Cette chimie de gravure a pour avantage d'améliorer l'anisotropie de la gravure. Cette anisotropie permet de ne pas graver les surfaces qui sont parallèles à la direction privilégiée de gravure. Dans le cas d'un transistor FinFET, l'anisotropie de la gravure permet de ne pas graver les portions 14g de couche diélectrique 14 situées sur les flancs de la grille 130 et destinée à former les espaceurs 140 du transistor. Le contrôle dimensionnel, selon y, de ces espaceurs 140 impactant directement les performances du transistor, il est important de ne pas graver involontairement la couche diélectrique 14 sur les flancs de la grille 130.

De préférence, la chimie fluorocarbonée comprend également au moins une espèce additionnelle de dilution ou de dissociation telle que l'argon (Ar), l'hélium (He), l'azote (N) ou l'oxygène (O). Le plasma peut être continu ou pulsé.

Selon un exemple, les conditions de cette gravure préalable sont les suivantes : le plasma est formé à partir de CHF3 présentant un débit de 30 sccm, et à partir d'hélium présentant un débit de 220 sccm. La puissance de la source est de 300 W et la tension de polarisation (bias) est de 65 V. La pression est de 5 milliTorr. La température du substrat de support est de 60°C. Le temps de gravure est de 20s. Cela permet typiquement de graver environ 6 nm de SiN.

Les figures 3E à 3G illustrent différentes étapes d'une séquence d'étapes qui peut être réitérée jusqu'à obtenir le résultat qui est illustré en figure 3H.

Comme illustré en figure 3E, à l'issue de la gravure préalable, ou après le dépôt de la couche diélectrique 14 (dans le cas où il n'y a pas de gravure préalable), on effectue une première gravure de la couche diélectrique 14.

Cette première gravure est configurée de manière à graver le matériau de la couche diélectrique 14 préférentiellement au matériau de protection de la couche de protection intercalaire 20.

Par ailleurs, cette gravure est configurée de manière à:
- s'interrompre avant de consommer toute la hauteur selon z de la portion latérale 14f de la couche diélectrique, située au niveau du flanc 32 ;
- former une première couche de protection 50a au-dessus de la structure 30 et
- former une deuxième couche de protection 60 sur une partie supérieure de la portion latérale 14f de la couche diélectrique, l'épaisseur e50a de la première couche de protection 50a étant supérieure à l'épaisseur e60a la deuxième couche de protection 60.

Cette première gravure est de préférence une gravure plasma. Cette première gravure de la couche diélectrique 14 utilise une chimie comprenant :
- au moins un premier composé à base de fluor (F) et
- au moins un deuxième composé pris parmi le SiwCI(2w+2) et le SiwF(2w+2) w, x, y et z étant des entiers,
- de l'oxygène (O).

Le premier composé à base de fluor permet une gravure efficace de la couche diélectrique 14 avec une bonne anisotropie.

Le deuxième composé permet d'améliorer la sélectivité de la gravure de la couche diélectrique vis-à-vis de la couche de protection intercalaire sous-jacente, par exemple en SiCO.

La quantité du premier composé à base de fluor est régulée de manière à consommer tous les composés à base de fluor, et donc à interrompre la première gravure avant de consommer toute l'épaisseur (prise selon l'axe Z) de la portion latérale 14f de couche diélectrique 14 qui est située contre le flanc 32.

Selon un mode de réalisation particulièrement avantageux, le premier composé à base de fluor a été intégralement introduit lors de l'étape préalable de gravure illustrée en figure 3D. Le fluor subsistant à l'issue de cette étape préalable de gravure est utilisé lors de ladite première gravure jusqu'à être entièrement consommé.

Alternativement, une partie ou l'intégralité des composés à base de fluor consommé lors de cette première gravure est introduite dans le réacteur plasma durant cette première gravure.

La présence d'oxygène dans la chimie du plasma permet de former un oxyde à la surface des couches mises à nu. Tant qu'il y a des composés permettant la gravure des couches, typiquement le composé à base de fluor, la gravure ne permet pas la formation d'une couche d'oxyde. En revanche, une fois que les composés permettant la gravure ont été entièrement consommés, une ou des couches d'oxyde se forment sur les surfaces mises à nu. Ces couches d'oxyde croissent ou se déposent principalement selon z, selon la direction privilégiée de bombardement des ions issus du plasma. La composition et/ou l'épaisseur de ces couches d'oxyde peuvent varier en fonction de la nature des surfaces sur laquelle elles se forment. Ces couches d'oxyde sont typiquement à base de SiOx.

Avantageusement, le matériau de protection favorise la formation de ces couches d'oxyde.

Ainsi, une couche d'oxyde également appelée première couche de protection 50a se forme sur la surface mise à nu de la couche de protection intercalaire 20 protégeant le sommet 31 de la structure 30. Cette première couche de protection 50 est par exemple de type SixOyFz, si le matériau de protection est à base de SiCO.

Une couche d'oxyde également appelée deuxième couche de protection 60 se forme sur la partie supérieure de la portion latérale 14f de couche diélectrique située contre le flanc 32 du Fin 30. Cette deuxième couche de protection 60 est par exemple de type SixOyNwFz, si la couche diélectrique 40 est à base de SiN.

Une couche d'oxyde également appelée troisième couche de protection 51a se forme sur la surface mise à nu de la couche de protection intercalaire 20 protégeant la face supérieure 120 du substrat. Cette troisième couche de protection 51a est par exemple de type SixOyFz, si le matériau de protection de la couche de protection intercalaire 20 est à base de SiCO.

La formation de la première couche de protection 50a est privilégiée du fait de la nature du matériau de protection, typiquement en SiCO.

Il s'ensuit que l'épaisseur e50a de la couche de protection 50a est supérieure à l'épaisseur e60a de la couche de protection 60 formée sur la portion latérale 14f. Typiquement, e50a ≥k1.e60a, avec k1=1.5 et de préférence k1=2 et de et de préférence k1=3.

De manière avantageuse, la couche de protection 51a présente une épaisseur e51a supérieure à l'épaisseur e60a de la couche de protection 60 située sur la portion latérale 14f. Typiquement, e51a ≥. k2.e60a, avec k2=1.5 et de préférence k2=2 et de préférence k2=3.

De préférence, la chimie utilisée pour cette première gravure comprend également des espèces de dilution ou de dissociation telle que l'argon, l'hélium ou l'azote. Le plasma peut être continu ou pulsé. De manière générale, un plasma pulsé permet de limiter l'endommagement des couches sous-jacentes. La fréquence du plasma pulsé est de préférence comprise entre 200 Hz et 5 kHz, de préférence de l'ordre de 500 Hz, avec un taux d'activation de 10% à 90% et typiquement de 50%.

Par exemple, au cours de cette première gravure, on utilise pour le plasma une chimie comprenant :
- du CxHyFz, par exemple du CH3F,
- du SiCl4 dont le débit est compris entre 2 et 15 sccm et de préférence entre 2 et 5 sccm,
- de l'oxygène,
- éventuellement un gaz de dissociation telle que l'Ar, l'He ou le N2.

Selon un exemple, les conditions de la première gravure sont les suivantes : le plasma est formé à partir d'un mélange de CH3F présentant un débit de 200 sccm, d'hélium présentant un débit de 120 sccm, de SiCl4 présentant un débit de 5 sccm, et d'oxygène présentant un débit de 200 sccm. La puissance de la source est de 400 W et la tension de polarisation (bias) est de 250 V. La pression est de 90 milliTorr. La température du substrat de support est de 60°C. Le temps de gravure est de 30s. Cela permet de former une première couche de protection de 4 à 5 nm d'épaisseur sur les parties exposées de la couche de protection intercalaire tout en ayant consommé 5 à 7 nm de SiN de la portion latérale de couche diélectrique.

Typiquement, au-delà d'une durée de 30 à 35 secondes, la portion latérale 14f de couche diélectrique SiN n'est plus gravée et la deuxième couche de protection 60 en oxyde commence à se déposer sur le SiN. On peut en déduire que les espèces participant activement à la gravure, telle que le composé à base de fluor (F), ne sont plus présents en quantité suffisante au-delà de cette durée. Au bout de cette durée, on peut donc interrompre la première gravure, puis mettre en oeuvre la deuxième gravure.

L'homme du métier saura déterminer des conditions de fonctionnement adaptées aux matériaux et aux épaisseurs de son application. Ainsi, il saura déterminer la teneur en SixCly ou SixFy dans le mélange ainsi que le temps de gravure.

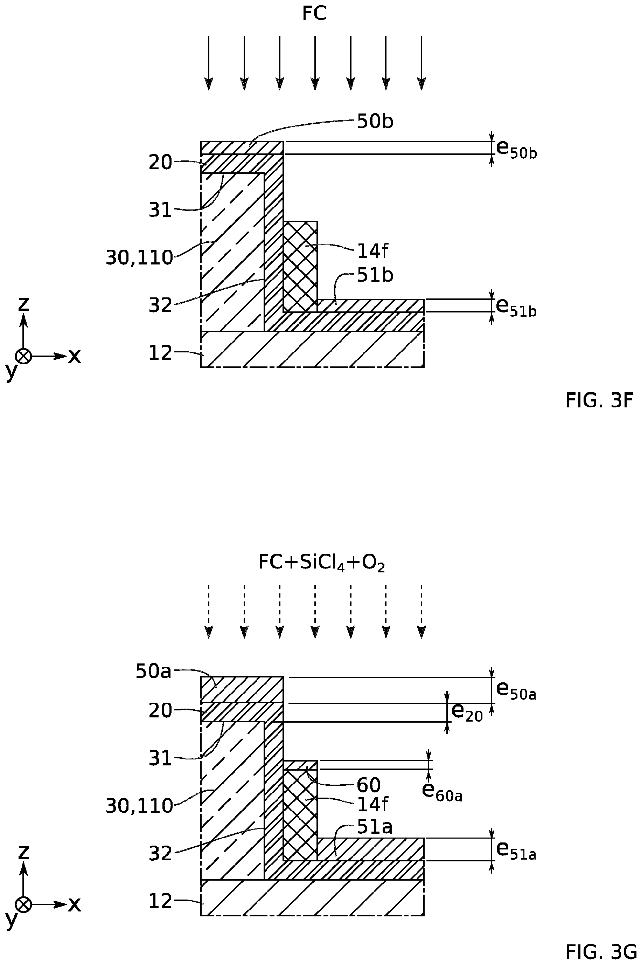

Comme illustré en figure 3F, à l'issue de la première gravure, on effectue une deuxième gravure.

Les première et deuxième gravures, et optionnellement la gravure préalable, sont de préférence effectuées dans un même équipement de gravure, par exemple de type réacteur plasma à couplage inductif (ICP), ou réacteur plasma à couplage capacitif (CCP). Les première et deuxième gravures peuvent ainsi être réalisées de façon cyclique *in situ* dans le même réacteur.

La première gravure peut être prolongée au début de la deuxième gravure, pendant un temps dit de surgravure, ou « overetch (OE) » selon la terminologie courante.

La deuxième gravure vise à retirer entièrement la deuxième couche de protection 60 située sur la partie supérieure de la portion latérale 14f de couche diélectrique tout en conservant une portion 50b d'épaisseur e50b de la première couche de protection au niveau du sommet 31 du Fin 30.

Cet objectif est d'autant plus facilement atteint que l'épaisseur e50a de la première couche de protection 50a est plus épaisse que l'épaisseur e60a de la deuxième couche de protection 60.

Par ailleurs, au cours de cette étape, on conserve également une portion 51b d'épaisseur e51b de la troisième couche de protection formée au-dessus de la couche isolante 12.

La deuxième gravure est anisotrope, dirigée principalement selon z. Elle est effectuée par plasma à partir d'une chimie comprenant un composé à base de fluor (F). De préférence, cette chimie comprend une espèce fluorocarbonée, par exemple pris parmi les espèces suivants CxHyFz ou CxFy, x, y et z étant des entiers, tel que le CF4 par exemple. Ainsi, on pourra utiliser la même chimie que pour l'étape de gravure préalable, de préférence avec une tension de polarisation (habituellement désignée bias) plus faible qu'au cours de la gravure préalable, ceci afin de limiter la consommation des couches sous-jacentes.

Il est également possible d'utiliser des chimies à base de SxFy, tel que le SF6. De préférence, la chimie fluorocarbonée comprend également au moins une espèce additionnelle de dilution ou de dissociation telle que l'argon (Ar), l'oxygène (O), l'hélium (He) ou l'azote (N). L'argon peut avoir pour inconvénient de rendre la vitesse de gravure trop élevée. Typiquement, l'épaisseur de la couche de protection que l'on grave au cours de cette deuxième étape de gravure est inférieure à 4 nm et de préférence inférieure à 2 nm.

Selon un exemple, les conditions de cette deuxième gravure sont les suivantes : le plasma est formé à partir de CF4 présentant un débit de 50 sccm. La puissance de la source est de 1200 W. La pression est de 100 milliTorr. Dans ces conditions, la vitesse de gravure du SiOx des couches de protection est de l'ordre de 4 nm/min.

Cette deuxième étape de gravure peut être interrompue au temps, après que toute la couche de protection 60 soit consommée et de préférence avant que toute la couche de protection 50b, 51b soit consommée.

À l'issue de cette deuxième étape de gravure, la séquence d'étapes comprenant la première étape de gravure et la deuxième étape de gravure est réitérée. Les première et deuxième gravures sont ainsi répétées alternativement.

Tout au long de chaque séquence, le sommet 31 du Fin 30 reste protégé à la fois par la première couche de protection 50a, 50b formée lors de la première étape de gravure de chaque séquence, et par la couche de protection intercalaire 20 sous-jacente. Il en est de même pour la face supérieure 120 de la couche isolante 12 qui reste protégée par la couche de protection 60a, 60b et par la couche de protection intercalaire 20 sous-jacente. Au cours de chaque première gravure, la portion latérale 14f de couche diélectrique 14 a quant à elle été fortement consommée.

Comme illustré en figure 3G, à l'issue de la deuxième gravure, on effectue une nouvelle première gravure. On voit sur cette figure 3G que la hauteur e30 du Fin 30 n'a pas été consommée et que le sommet 31 du Fin 30 est toujours recouvert par la couche de protection intercalaire 20 et par une couche de protection 50a. La portion latérale 14f de couche diélectrique 14 au niveau du flanc 32 du Fin 30 a quant à elle été significativement consommée.

La figure 3H illustre le résultat que l'on obtient lorsque la gravure du SiN est arrêtée à l'issue d'une première étape de gravure voire d'une deuxième étape de gravure après avoir réitéré la séquence d'étapes. Comme illustré, la portion 14f de couche diélectrique 14 contre le flanc 32 du Fin 30 est entièrement consommée. En revanche, la hauteur e30 du Fin 30 n'a pas été consommée. Le sommet 31 du Fin 30 est toujours recouvert par la couche de protection intercalaire 20 et par une couche de protection d'oxyde 50a, 50b. La face supérieure 120 de la couche isolante 12 est toujours recouverte par la couche de protection intercalaire 20 et par une couche de protection d'oxyde 51a, 51b qui n'est pas nécessairement continue ou uniforme en épaisseur.

Des séquences additionnelles de première et deuxième gravures peuvent être effectuées de façon à consommer toute la hauteur de portion latérale 14f.

On peut ensuite retirer les couches de protection 50b, 51b à base de SiOx ou de SiOCI. Pour cela on pourra avantageusement procéder à un retrait par plasma d'oxygène, typiquement au sein du même réacteur que celui utilisé pour les première et deuxième gravures. Le plasma d'oxygène permet à la fois de retirer les couches de protection 50b, 51b résiduelles, et de modifier la couche de protection intercalaire 20m. En étant exposé au plasma O2, le matériau de protection SiCO se transforme en SiOx. La couche de protection intercalaire modifiée 20m est alors à base de SiOx. Une telle couche peut alors être facilement retirée, typiquement par voie humide, par exemple en utilisant un bain HF (acide fluorhydrique) dilué à 1%. Selon les cas, il est possible que l'on ait une légère consommation de la couche isolante 12. De façon générale, la couche de protection intercalaire modifiée 20m à base d'oxyde est peu dense et se gravera plus vite que l'oxyde de type BOX de la couche isolante. Ainsi, la consommation de l'oxyde de type BOX de la couche isolante reste très faible, voire inexistante.

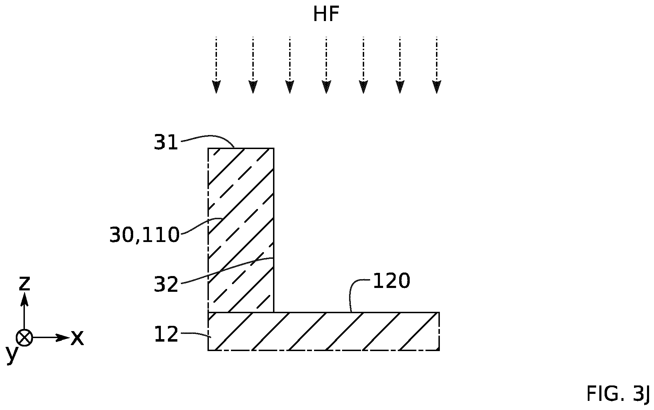

La figure 3J illustre le résultat obtenu après retrait de la couche de protection intercalaire modifiée 20m. Le Fin 30 est entièrement exposé, sans avoir été endommagé.

Optionnellement, avant gravure de la couche diélectrique 14, c'est-à-dire avant l'étape préalable si elle est effectuée ou avant la première séquence comprenant les première et deuxième gravures, on peut effectuer une étape de protection des flancs 33 de la couche diélectrique 14 (figure 3C). En effet, au cours des différentes gravures, on cherche à graver la couche diélectrique 14 selon une direction Z perpendiculaire au plan XY du substrat 10. Ainsi, il peut être avantageux de limiter la consommation latérale (selon l'axe X) de la couche diélectrique 14. Pour cela, on peut former, de préférence par oxydation, une couche de protection latérale sur la couche diélectrique 14.

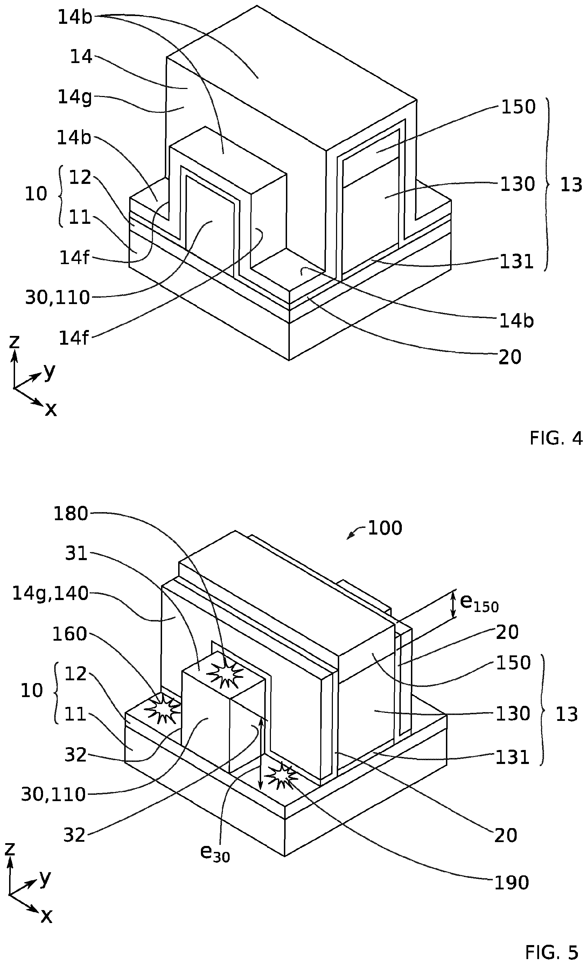

Dans le cas de la réalisation d'un transistor FinFET, on souhaite conserver la portion 14g de couche diélectrique 14 sur les flancs de la grille 130 tout en exposant entièrement les Fins 30 (figures 4, 5). Cette portion 14g est typiquement séparée des flancs de la grille 130 par la couche de protection intercalaire 20 (figure 4). Avantageusement, en utilisant un matériau de protection à base de SiCO, la couche de protection intercalaire modifiée 20m est éliminée en fin de procédé par HF tandis qu'une portion 20g de la couche de protection intercalaire 20 non modifiée est conservée sur les flancs de la grille 130 (figure 5), du fait de la résistance au HF du SiCO. Cela évite un phénomène de décollement ou lift off de la portion 14g lors du retrait par HF en voie humide.

Les flancs de la grille 130 et les flancs 32 du Fin 30 sont généralement tous deux perpendiculaires au plan principal XY du substrat de support 10, et sont généralement parallèles à la direction principale Z d'implantation des ions issus du plasma. Afin d'éviter de consommer toute la couche diélectrique sur les flancs de la grille 130 lors du retrait de cette même couche sur les flancs des Fins 30, on prévoit que l'épaisseur e150 du masque dur 150 surmontant la grille 130 soit supérieure ou égale à l'épaisseur e30 du Fin 30. Ainsi, lorsque les portions latérales 14f de couche diélectrique 14 portées par les flancs 32 du Fin 30 seront entièrement consommées, la couche diélectrique 14 aura été consommée sur une partie au moins de l'épaisseur du masque dur 150 mais continuera de recouvrir intégralement les flancs de la grille 130. Les espaceurs 140 ainsi formés comprennent chacun typiquement la portion 14g de couche diélectrique et la portion 20g de couche de protection intercalaire 20 restante (figure 5). Avantageusement, le matériau de protection de la couche de protection intercalaire 20 est choisi de façon à présenter une constante diélectrique k adaptée à la fabrication d'espaceurs, typiquement k ≤ 4.

Au vu de la description qui précède, il apparaît clairement que la présente invention propose une solution efficace pour graver entièrement et avec une grande précision la couche diélectrique sur le sommet et les flancs d'une structure 3D tout en évitant d'endommager cette structure 3D.

L'invention n'est pas limitée aux modes de réalisation précédemment décrits.

Par exemple, le procédé peut ne pas comprendre d'étape préalable de gravure. Ainsi, la gravure de la couche diélectrique est uniquement opérée par les séquences comprenant les première et deuxième gravures.

Bien qu'elle trouve pour application particulièrement avantageuse la réalisation des transistors de type FinFET, l'invention s'applique à toutes les gravures d'une couche diélectrique sur une structure en trois dimensions. Ainsi, elle trouvera pour application la réalisation de transistors à base de nanofils, en particulier à base de nanofils empilés.

## Revendications

1. Procédé de gravure d'une couche diélectrique (14) en un matériau diélectrique recouvrant au moins un sommet (31) et un flanc (32) d'une structure (30) tridimensionnelle, ledit procédé comprenant un dépôt de ladite couche diélectrique (14) sur le sommet (31) et le flanc (32) de la structure (30) tridimensionnelle, ledit procédé comprenant une pluralité de séquences comprenant chacune au moins les étapes successives suivantes :
- une première gravure de la couche diélectrique (14), par un premier plasma à base d'une chimie comprenant :
∘ au moins un premier composé à base de fluor (F) et
∘ de l'oxygène (O)
ladite première gravure étant effectuée de manière à :
∘ générer un bombardement ionique dirigé principalement selon une direction (Z), parallèle audit flanc (32),
∘ réguler la quantité de l'au moins un premier composé pour consommer tout ledit premier composé à base de fluor lors de cette première gravure de manière à interrompre la première gravure avant consommation de toute l'épaisseur de la couche diélectrique (14, 14f) située sur le flanc (32) et après avoir consommé toute l'épaisseur de la couche diélectrique (14, 14b) située au niveau du sommet (31),
∘ former une première couche de protection (50a) à base d'oxyde au niveau du sommet (31) de la structure (30) tridimensionnelle et former une deuxième couche de protection (60) à base d'oxyde sur une portion supérieure de la couche diélectrique (14, 14f) située sur le flanc (32), l'épaisseur e50a de la première couche de protection (50a) étant supérieure à l'épaisseur e60a de la deuxième couche de protection (60),
- une deuxième gravure dirigée principalement selon la direction (Z) parallèle audit flanc (32),
ladite deuxième gravure étant configurée pour :
∘ retirer entièrement la deuxième couche de protection (60) tout en conservant une portion (50b) d'épaisseur e50b de la première couche de protection (50a, 50b, 50m) au-dessus du sommet de la structure (31),
ladite séquence de première et deuxième gravures étant répétée jusqu'au retrait complet de la couche diélectrique (14, 14f) située sur le flanc (32) de la structure (30) tridimensionnelle,
ledit procédé étant **caractérisé en ce qu'**il comprend en outre, avant le dépôt de la couche diélectrique (14), une formation d'une couche de protection intercalaire (20) à base d'un matériau de protection différent du matériau diélectrique, la couche de protection intercalaire (20) étant formée de sorte à recouvrir entièrement la structure (30) tridimensionnelle et de sorte que ladite couche de protection intercalaire (20) soit située entre ledit sommet (31) et la couche diélectrique (14).

2. Procédé selon la revendication précédente dans lequel le matériau de protection est à base de SiXO, X étant une espèce prise parmi le carbone (C) et l'azote (N), de sorte que la couche de protection intercalaire (20) favorise la formation de la première couche de protection (50a) à base d'oxyde.

3. Procédé selon l'une quelconque des revendications précédentes dans lequel le matériau de protection est choisi de façon à présenter une résistance à la gravure par l'acide fluorhydrique (HF), telle qu'une vitesse de gravure dudit matériau par une solution à base de HF soit inférieure à 5 nm/min.

4. Procédé selon l'une quelconque des revendications précédentes dans lequel le matériau de protection est choisi de façon à présenter une constante diélectrique k inférieure ou égale à 4.

5. Procédé selon l'une quelconque des revendications précédentes dans lequel le premier plasma comprend en outre au moins un deuxième composé pris parmi le SiwCI(2w+2) et le SiwF(2w+2), w étant un entier non nul.

6. Procédé selon l'une quelconque des revendications précédentes dans lequel la deuxième gravure est effectuée par un deuxième plasma à base d'au moins une espèce fluorocarbonée CxHyFz, x, y et z étant des entiers.

7. Procédé selon l'une quelconque des revendications précédentes dans lequel la formation de la couche de protection intercalaire (20) est configurée de sorte à ce que la couche de protection intercalaire (20) présente une épaisseur e20 comprise entre 2 nm et 5 nm.

8. Procédé selon l'une quelconque des revendications précédentes dans lequel la première gravure est configurée de sorte à ce que la première couche de protection (50a) à base d'oxyde formée présente une épaisseur e50a supérieure ou égale à 5 nm.

9. Procédé selon l'une quelconque des revendications précédentes dans lequel la deuxième gravure est configurée de sorte à ce que la portion de la première couche de protection (50b) conservée présente une épaisseur e50b supérieure ou égale à 2 nm.

10. Procédé selon l'une quelconque des revendications précédentes comprenant en outre, après retrait complet de la couche diélectrique (14, 14f) située sur le flanc (32) de la structure (30) tridimensionnelle, une étape d'oxydation de la couche de protection intercalaire (20) suivie d'une étape de retrait de la couche de protection intercalaire oxydée (20b).

11. Procédé selon la revendication précédente dans lequel le matériau de protection de la couche de protection intercalaire (20) est du SiCO, et l'étape d'oxydation est effectuée par un plasma à base d'oxygène de sorte que la couche de protection intercalaire oxydée (20m) soit à base de SiO2.

12. Procédé selon la revendication précédente dans lequel l'étape de retrait de la couche de protection intercalaire oxydée (20m) se fait par une solution de gravure à base d'acide fluorhydrique (HF).

13. Procédé selon l'une quelconque des revendications précédentes dans lequel la structure (30) est en un matériau semi-conducteur et forme un canal (110) d'un transistor FinFET.

14. Procédé de réalisation d'un transistor FinFET (100) surmontant un substrat de support (10), le transistor FinFET (100) comprenant un motif de grille (13) et au moins un canal (110) traversant le motif de grille (13) et s'étendant depuis un flanc du motif de grille (13) pour former au moins une structure (30) en un matériau semi-conducteur, ladite structure (30) présentant un sommet (31) et au moins deux flancs (32), le procédé comprenant :
- la gravure de la couche diélectrique (14) en mettant en oeuvre le procédé selon l'une quelconque des revendications précédentes, de manière à retirer complètement la couche diélectrique (14, 14f, 14b) située sur la structure (30) formée par le canal (110), en conservant une portion (14g) de couche diélectrique (14) sur le flanc du motif de grille (13), de façon à ce que ladite portion (14g) forme un espaceur (140) du transistor FinFET (100).

15. Procédé selon la revendication précédente dans lequel le motif de grille (13) comprend une grille (130) et un masque dur (150) surmontant un sommet de la grille (130), le masque dur (150) présentant une épaisseur e150, tel que e150 ≥ e30, e30 étant la hauteur de la structure (30), et de préférence e150 ≥ 1.2 * e30.

## Patentansprüche

1. Verfahren zur Gravur einer dielektrischen Schicht (14) aus einem dielektrischen Material, die mindestens eine Spitze (31) und eine Flanke (32) einer dreidimensionalen Struktur (30) bedeckt, wobei das Verfahren eine Abscheidung der dielektrischen Schicht (14) auf der Spitze (31) und der Flanke (32) der dreidimensionalen Struktur (30) umfasst, wobei das Verfahren eine Vielzahl von Sequenzen umfasst, die jeweils mindestens die folgenden aufeinanderfolgenden Schritte umfassen:
- eine erste Gravur der dielektrischen Schicht (14), durch ein erstes Plasma auf der Basis einer Chemie, die Folgendes umfasst:
∘ mindestens eine erste Verbindung auf Fluorbasis (F) und
∘ Sauerstoff (O)
wobei die erste Gravur so durchgeführt wird, um:
∘ einen Ionenbeschuss zu erzeugen, der hauptsächlich in einer Richtung (Z) parallel zu der Flanke (32) gerichtet ist,
∘ die Menge der mindestens einen ersten Verbindung zu regulieren, um die gesamte erste Verbindung auf Fluorbasis bei dieser ersten Gravur zu verbrauchen, so dass die erste Gravur vor dem Verbrauch der gesamten Dicke der an der Flanke (32) befindlichen dielektrischen Schicht (14, 14f) und nach dem Verbrauch der gesamten Dicke der an der Spitze (31) befindlichen dielektrischen Schicht (14, 14b) unterbrochen wird,
∘ eine erste Schutzschicht (50a) auf Oxidbasis an der Spitze (31) der dreidimensionalen Struktur (30) zu bilden und eine zweite Schutzschicht (60) auf Oxidbasis auf einem oberen Abschnitt der dielektrischen Schicht (14, 14f) zu bilden, der sich an der Flanke (32) befindet, wobei die Dicke e50a der ersten Schutzschicht (50a) größer ist als die Dicke e60a der zweiten Schutzschicht (60),
- eine zweite Gravur, die hauptsächlich entlang der Richtung (Z) parallel zu der Flanke (32) gerichtet ist, wobei die zweite Gravur konfiguriert ist, um:
∘ die zweite Schutzschicht (60) vollständig zu entfernen, während ein Abschnitt (50b) der Dicke e50b der ersten Schutzschicht (50a, 50b, 50m) über der Oberseite der Struktur (31) erhalten bleibt,
wobei der Abschnitt der ersten und zweiten Gravur wiederholt wird, bis die dielektrische Schicht (14, 14f), die sich an der Flanke (32) der dreidimensionalen Struktur (30) befindet, vollständig entfernt ist,
wobei das Verfahren **dadurch gekennzeichnet ist, dass** es ferner vor dem Aufbringen der dielektrischen Schicht (14) eine Bildung einer dazwischenliegenden Schutzschicht (20) auf der Basis eines Schutzmaterials umfasst, das sich von dem dielektrischen Material unterscheidet, wobei die dazwischenliegende Schutzschicht (20) so gebildet wird, dass sie die dreidimensionale Struktur (30) vollständig bedeckt und so, dass die dazwischenliegende Schutzschicht (20) zwischen dem Scheitelpunkt (31) und der dielektrischen Schicht (14) angeordnet ist.

2. Verfahren nach dem vorhergehenden Anspruch, wobei das Schutzmaterial auf SiXO-Basis ist, wobei X eine Spezies aus Kohlenstoff (C) und Stickstoff (N) ist, so dass die dazwischenliegende Schutzschicht (20) die Ausbildung der ersten Schutzschicht (50a) auf Oxidbasis fördert.

3. Verfahren nach einem der vorhergehenden Ansprüche, wobei das Schutzmaterial so ausgewählt wird, dass es eine Beständigkeit gegen die Gravur durch Fluorwasserstoffsäure (HF) aufweist, so dass eine Geschwindigkeit der Gravur des Materials durch eine Lösung auf HF-Basis weniger als 5 nm/min beträgt.

4. Verfahren nach einem der vorhergehenden Ansprüche, bei dem das Schutzmaterial so ausgewählt wird, dass es eine Dielektrizitätskonstante k von kleiner oder gleich 4 aufweist.

5. Verfahren nach einem der vorhergehenden Ansprüche, wobei das erste Plasma zusätzlich mindestens eine zweite Verbindung aus der Gruppe bestehend aus SiwCl(2w+2) und SiwF(2w+2) enthält, wobei w eine ganze Zahl ungleich Null ist.

6. Verfahren nach einem der vorhergehenden Ansprüche, wobei die zweite Gravur durch ein zweites Plasma auf der Basis von mindestens einer Fluorkohlenstoffspezies CxHyFz durchgeführt wird, wobei x, y und z ganze Zahlen sind.

7. Verfahren nach einem der vorhergehenden Ansprüche, wobei die Bildung der dazwischenliegenden Schutzschicht (20) so konfiguriert ist, dass die dazwischenliegende Schutzschicht (20) eine Dicke e20 zwischen 2 nm und 5 nm aufweist.

8. Verfahren nach einem der vorhergehenden Ansprüche, bei dem die erste Gravur so konfiguriert ist, dass die erste Schutzschicht (50a) auf Oxidbasis gebildet wird, eine Dicke e50a von 5 nm oder mehr aufweist.

9. Verfahren nach einem der vorhergehenden Ansprüche, wobei die zweite Gravur so konfiguriert ist, dass der Teil der ersten Schutzschicht (50b), der erhalten bleibt, eine Dicke e50b von 2 nm oder mehr aufweist.

10. Verfahren nach einem der vorhergehenden Ansprüche, das ferner nach vollständiger Entfernung der dielektrischen Schicht (14, 14f), die sich auf der Flanke (32) der dreidimensionalen Struktur (30) befindet, einen Schritt der Oxidation der dazwischenliegenden Schutzschicht (20), gefolgt von einem Schritt der Entfernung der oxidierten dazwischenliegenden Schutzschicht (20b), umfasst.

11. Verfahren nach dem vorhergehenden Anspruch, bei dem das Schutzmaterial der dazwischenliegenden Schutzschicht (20) SiCO ist und der Oxidationsschritt durch ein Plasma auf Sauerstoffbasis durchgeführt wird, so dass die oxidierte dazwischenliegende Schutzschicht (20m) auf SiO2 basiert.

12. Verfahren nach dem vorhergehenden Anspruch, bei dem der Schritt des Entfernens der oxidierten dazwischenliegenden Schutzschicht (20m) durch eine Gravurlösung auf der Basis von Fluorwasserstoffsäure (HF) erfolgt.

13. Verfahren nach einem der vorhergehenden Ansprüche, bei dem die Struktur (30) aus einem Halbleitermaterial besteht und einen Kanal (110) eines FinFET-Transistors bildet.

14. Verfahren zum Herstellen eines FinFET-Transistors (100) auf einem Trägersubstrat (10), wobei der FinFET-Transistor (100) ein Gate-Muster (13) und mindestens einen Kanal (110) umfasst, der durch das Gate-Muster (13) verläuft und sich von einer Flanke des Gate-Musters aus erstreckt (13), um mindestens eine Struktur (30) aus einem Halbleitermaterial zu bilden, wobei die Struktur (30) einen Scheitelpunkt (31) und mindestens zwei Flanken (32) aufweist, wobei das Verfahren umfasst:
- die Gravur der dielektrischen Schicht (14) durch Ausführen des Verfahrens nach einem der vorhergehenden Ansprüche, um die dielektrische Schicht (14, 14f, 14b), die sich auf der durch den Kanal (110) gebildeten Struktur (30) befindet, vollständig zu entfernen, wobei ein Bereich (14g) der dielektrischen Schicht (14) an der Flanke des Gate-Musters (13) erhalten bleibt, so dass dieser Bereich (14g) einen Abstandshalter (140) des FinFET-Transistors (100) bildet.

15. Verfahren nach dem vorhergehenden Anspruch, wobei das Gate-Muster (13) ein Gitter (130) und eine harte Maske (150) umfasst, die über einem Scheitelpunkt des Gitters (130) liegt, wobei die harte Maske (150) eine Dicke e150 aufweist, so dass e150 ≥ e30, wobei e30 die Höhe der Struktur (30) ist, und vorzugsweise e150 ≥ 1.2 * e30.

## Claims

1. A method for etching a dielectric layer (14) made of a dielectric material covering at least one top (31) and one side (32) of a three-dimensional structure (30), said method comprising a deposition of said dielectric layer (14) on the top (31) and the side (32) of the three-dimensional structure (30), said method comprising a plurality of sequences each comprising at least the following successive steps:
- a first etching of the dielectric layer (14), by a first plasma based on a chemistry comprising:
∘ at least a first fluorine (F)-based compound and
∘ oxygen (O)
said first etching being carried out so as to:
∘ generate an ion bombardment directed mainly in a direction (Z), parallel to said side (32),
∘ regulate the amount of the at least one first compound to consume all of said first fluorine-based compound during this first etching so as to interrupt the first etching before consuming the entire thickness of the dielectric layer (14, 14f) located on the side (32) and after having consumed the entire thickness of the dielectric layer (14, 14b) located at the top (31),
∘ form a first protective oxide-based layer (50a) at the top (31) of the three-dimensional structure (30) and form a second protective oxide-based layer (60) on an upper portion of the dielectric layer (14, 14f) located on the side (32), the thickness e50a of the first protective layer (50a) being greater than the thickness e60a of the second protective layer (60),
- a second etching directed mainly in the direction (Z) parallel to said side (32), said second etching being configured for:
∘ completely removing the second protective layer (60) while retaining a portion (50b) of the thickness e50b of the first protective layer (50a, 50b, 50m) above the top of the structure (31),
said sequence of first and second etchings being repeated until complete removal of the dielectric layer (14, 14f) located on the side (32) of the three-dimensional structure (30),
said method being **characterised in that** it further comprises, before deposition of the dielectric layer (14), a formation of an intermediate protective layer (20) based on a protective material different from the dielectric material, the intermediate protective layer (20) being formed so as to completely cover the three-dimensional structure (30) and such that said intermediate protective layer (20) is located between said top (31) and the dielectric layer (14).

2. The method according to the preceding claim wherein the protective material is based on SiXO, X being a species taken from carbon (C) and nitrogen (N), so that the intermediate protective layer (20) promotes the formation of the first oxide-based protective layer (50a).

3. The method according to any one of the preceding claims wherein the protective material is chosen so as to have resistance to etching by hydrofluoric acid (HF), such that a speed of etching said material by an HF-based solution is less than 5 nm/min.

4. The method according to any one of the preceding claims wherein the protective material is chosen so as to have a dielectric constant k less than or equal to 4.

5. The method according to any one of the preceding claims wherein the first plasma further comprises at least one second compound taken from SiwCl(2w+2) and SiwF(2w+2), w being a non-zero integer.

6. The method according to any one of the preceding claims wherein the second etching is carried out by a second plasma based on at least one fluorocarbon species CxHyFz, x, y and z being integers.

7. The method according to any one of the preceding claims wherein the formation of the intermediate protective layer (20) is configured so that the intermediate protective layer (20) has a thickness e20 comprised between 2 nm and 5 nm.

8. The method according to any one of the preceding claims wherein the first etching is configured so that the first protective oxide-based layer (50a) formed has a thickness e50a greater than or equal to 5 nm.

9. The method according to any one of the preceding claims wherein the second etching is configured so that the portion of the first protective layer (50b) retained has a thickness e50b greater than or equal to 2 nm.

10. The method according to any one of the preceding claims further comprising, after complete removal of the dielectric layer (14, 14f) located on the side (32) of the three-dimensional structure (30), a step of oxidising the intermediate protective layer (20) followed by a step of removing the oxidised intermediate protective layer (20b).

11. The method according to the preceding claim wherein the protective material of the intermediate protective layer (20) is SiCO, and the oxidation step is carried out by an oxygen-based plasma so that the oxidised intermediate protective layer (20m) is based on SiO2.

12. The method according to the preceding claim wherein the step of removing the oxidised intermediate protective layer (20m) is carried out using an etching solution based on hydrofluoric acid (HF).

13. The method according to any one of the preceding claims wherein the structure (30) is made of a semiconductor material and forms a channel (110) of a FinFET transistor.

14. A method for producing a FinFET transistor (100) surmounting a support substrate (10), the FinFET transistor (100) comprising a gate pattern (13) and at least one channel (110) passing through the gate pattern (13) and extending from a side of the gate pattern (13) to form at least one structure (30) made of a semiconductor material, said structure (30) having a top (31) and at least two sides (32), the method comprising:
- etching the dielectric layer (14) by implementing the method according to any one of the preceding claims, so as to completely remove the dielectric layer (14, 14f, 14b) located on the structure (30) formed by the channel (110), retaining a portion (14g) of dielectric layer (14) on the side of the gate pattern (13), so that said portion (14g) forms a spacer (140) of the FinFET transistor (100).

15. The method according to the preceding claim wherein the grid pattern (13) comprises a grid (130) and a hard mask (150) surmounting a top of the grid (130), the hard mask (150) having a thickness e150, such that e150 ≥ e30, e30 being the height of the structure (30), and preferably e150 ≥ 1.2 * e30.
